# EUROPÄISCHE PATENTSCHRIFT

(11) **EP 0 927 510 B1**
(45) Veröffentlichungstag und Bekanntmachung des Hinweises auf die Patenterteilung: **12.12.2001**
(21) Anmeldenummer: 98925638.3
(22) Anmeldetag: 27.05.1998
(51) Int. Cl.: H05K 7/20, H05K 5/04

(54) **WÄRMEABLEITENDES GEHÄUSE ZUR AUFNAHME VON ELEKTRISCHEN ODER ELEKTRONISCHEN BAUTEILEN**
HEAT-CONDUCTING HOUSING TO ACCOMMODATE ELECTRICAL OR ELECTRONIC COMPONENTS
BOITIER DISSIPATEUR DE CHALEUR SERVANT A LOGER DES COMPOSANTS ELECTRIQUES OU ELECTRONIQUES

(30) Priorität: 30.05.1997 DE 19722602
(43) Veröffentlichungstag der Anmeldung: 07.07.1999
(73) Patentinhaber: Lenze GmbH & Co. KG Aerzen, D-31855 Aerzen (DE)
(72) Erfinder: HÜBNER, Karsten, D-31855 Aerzen (DE); DIEHL, Martin, D-31855 Aerzen (DE)
(74) Vertreter: Elbertzhagen, Otto, Dipl.-Ing.
(86) Internationale Anmeldenummer: EP9803112
(87) Internationale Veröffentlichungsnummer: WO9854940

(56) Entgegenhaltungen:
- US-A- 5 476 699

## Beschreibung

### TECHNISCHES GEBIET

Die Erfindung bezieht sich auf ein wärmeableitendes Gehäuse der im Gattungsbegriff des Patentanspruchs 1 näher bezeichneten Art.

### STAND DER TECHNIK

Ein solches aus einem im wesentlichen U-förmigen Strangpreßprofil aus Leichtmetall bestehendes Gehäuse zur Aufnahme von Halbleiterbauteilen mit Wärmekontaktelementen, die zur Wärmeableitung mit der Innenseite des U-Profils in Verbindung stehen, ist aus der Offenlegungsschrift DE 36 29 552 A1 bekannt. Zur Erzielung eines sicheren Wärmeübergangs werden bei der bekannten Ausführung die Halbleiterbauteile mit einem der Seitenteile des U-Profils verschraubt. Anstelle der Verschraubung können in anderer vorbekannter Bauart auch Federdruckelemente vorgesehen werden, vgl. DE 92 13 671 U1. Auch ist es bekannt, entsprechend ausgebildete Leistungshalbleiter mit Kühlkörpern zu verlöten.

Insgesamt erfordern die bekannten Verbindungstechniken zur Herstellung eines Wärmekontaktes in einem Gehäuse der in Rede stehenden Art, gleich, ob sie mechänisch-kraftflüssig oder stoffschlüssig funktionieren, einen erhöhten Bauteil-und Montageaufwand, womit zudem noch die Gefahr zusätzlicher Fehlerquellen verbunden ist.

### DIE ERFINDUNG

Der Erfindung liegt die Aufgabe zugrunde, ein wärmeableitendes Gehäuse der gattungsgemäßen Art zu schaffen, welches sich nach der Bestückung mit der zumindest einen Leiterplatte so verformen läßt, daß sich der Wärmekontakt zwischen dem Wärmekontaktelement der betreffenden Bauteile und der inneren Kontaktfläche im Kasten-Profil ohne zusätzlich zu montierende Teile selbsttätig herstellt.

Diese Aufgabe wird bei einem wärmeableitenden Gehäuse der gattungsbildenden Art nach der Erfindung durch die kennzeichnenden Merkmale des Patentanspruchs 1 gelöst.

Für die Erfindung ist wesentlich, daß das vorzugsweise an drei Umfangsseiten aus dem Leichtmetallprofil bestehende Gehäuse zumindest eine entweder schon beim Strangpressen aufgeweitet angeformte oder eine bei der Montage durch Verbiegen aufweitbare Seite hat, die nach dem Einbringen der bestückten Leiterplatte mit den daran unter anderem befindlichen elektronischen oder elektrischen Bauteilen, die mit je einem Wärmekontaktelement versehen sind, durch Eindrükken unter plastischer Verformung gerichtet und in ihre Endlage gebracht werden kann, in der sie vornehmlich rechtwinklig zu der Grundseite des Kasten-Profils ausgerichtet ist. Hierbei wird zugleich die thermische Kontaktierung zwischen den Wärmekontaktelementen der betreffenden Bauteile auf der Leiterplatte und der Kontaktfläche im Inneren des Gehäuses hergestellt, indem die gerichtete Gehäuseseite unmittelbar oder mittelbar über ein Zwischenglied das Wärmekontaktelement des Bauteils gegen die wärmeableitende Kontaktfläche am Gehäuse preßt. Hierzu sind die geometrischen Abmessungen so gewählt, daß ein solcher Anpreßdruck erzielt wird, der den thermischen Kontaktwiderstand zwischen den Wärmekontaktelementen der zu kühlenden Bauteile und der Kontaktfläche im Inneren des Kasten-Profils minimiert. Gleichzeitig kann diese Kontaktierung noch zur Herstellung eines Potentialausgleichs zwischen der Leiterplatte und dem kasten-förmigen Gehäuse mit entsprechenden PE-Schutzkontakten genutzt werden.

Vorteilhafte Ausgestaltungsmerkmale der Erfindung ergeben sich aus den Unteransprüchen.

### KURZBESCHREIBUNG DER ZEICHNUNGSABBILDUNGEN

Die Erfindung wird nachfolgend anhand der Zeichnung an einem Ausführungsbeispiel noch näher erläutert. Dabei zeigen:
- Fig. 1: die Querschnittsdarstellung eines im Querschnitt U-förmigen Strangpreßprofils aus Leichtmetall zur Herstellung eines wärmeableitenden Gehäuses,
- Fig. 2: eine schematische Querschnittsdarstellung eines aus dem Strangpreßprofil nach Figur 1 hergestellten, komplettierten Gehäuses,
- Fig. 3: eine schematische Querschnittsdarstellung eines aus dem Strangpreßprofil nach Fig. 1 hergestellten, in anderer Weise komplettierten Gehäuses und
- Fig. 4: eine schematische Querschnittsdarstellung eines aus einem im Querschnitt etwa C-förmigen Strangpreßprofil hergestellten, nach Art des Gehäuses von Fig. 3 komplettierten Gehäuses vor dem Schließen der richtbaren Gehäuseseite.

### BESTER WEG ZUR AUSFÜHRUNG DER ERFINDUNG

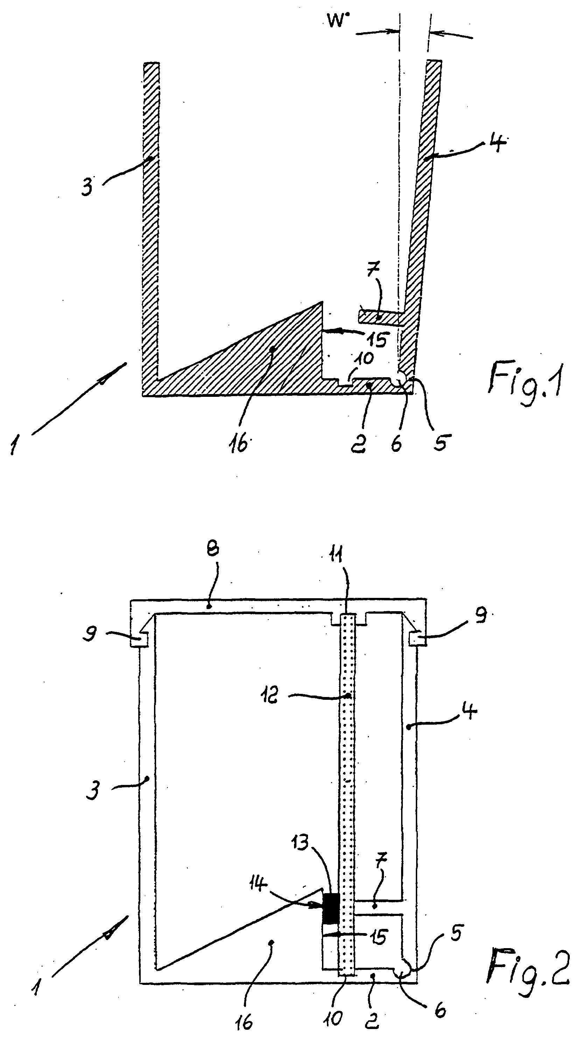

Im einzelnen zeigt Figur 1 ein im wesentlichen U-fömiges Strangpreßprofil 1, das. aus Leichtmetall, wie Aluminium, besteht. Das Profil 1 kann man als Kasten-Profil bezeichnen, weil es die Basis für ein kastenförmiges Gehäuse darstellt, welches die Gestalt eines Quaders oder eines Parallelepipeds hat und das folglich nach Einfügung von Stirnseiten rundum durch vier jeweils rechtwinklig zueinander stehenden Seiten geschlossen ist.

Das U-förmige Kasten-Profil 1 weist eine Grundseite 2 und daran längsseitig einstückig angeformte Flanschseiten 3 und 4 auf, wobei die in der Darstellung linke Flanschseite 3 rechtwinklig zu der Grundseite 2 ausgerichtet ist. Die rechte Flanschseite 4 des U-Profils 1 ist in der in Figur 1 gezeigten Ausgangslage etwas nach außen aufgeweitet und steht in einem leicht stumpfen Winkel zur Grundseite 2. Damit ergibt sich ein sehr spitzer Winkel W zwischen der Lotrechten auf die Grundseite 2 und der ebenen Flanschseite 4. Die Winkellage der Flanschseite 4 relativ zur Grundseite 2 kann entweder schon beim Strangpressen vorgesehen oder durch nachträgliche Verformung im Übergangsbereich dieser beiden Seiten 2, 4 hergestellt werden.

Die aufgeweitete Flanschseite 4 kann mit der Grundseite 2 über einen im Querschnitt geschwächten Wandabschnitt 5 verbunden sein, wozu in die Innenecke zwischen der Flanschseite 4 und der Grundseite 2 eine durchlaufende Einbuchtung 6 eingeformt wird. Der Wandabschnitt 5 im Übergangsbereich kann somit die Funktion eines plastisch verformbaren Filmscharniers übernehmen und läßt zur Eliminierung oder Rückstellung des Neigungswinkels W ein Eindrücken der Flanschseite 4 in Richtung zum Inneren des U-Profils 1 zu, so daß die Flanschseite 4 in ihrer gerichteten Endlage parallel zu der zweiten Flanschseite 3 des U-Profils 1 liegt.

In dem zu der Grundseite 2 hin liegenden Bereich weist die Flanschseite 4 an ihrer Innenseite ein vorstehendes Druckteil 7 in Gestalt eines Quersteges auf, dessen Funktion sich aus Figur 2 ergibt.

Ferner findet sich an der Grundseite 2 ein einstückig angeformter, nach innen gerichteter Vorsprung 16, der einen dreieckigen Querschnitt hat. Die kürzere Seite dieses dreieckigen Querschnittes bildet eine Kontaktfläche 15, deren Funktion anhand von Figur 2 erläutert werden wird. Diese Kontaktfläche 15, die senkrecht zur Grundseite 2 steht, hat einen mechanischen Druck aufzunehmen, der nahe der Oberkante des Vorsprungs 16 in Höhe des Druckteils 7 an der Flanschseite 4 aufzunehmen ist. Auch deshalb fällt der Querschnitt des Vorsprunges 16 auf der der Kontaktfläche 15 abgewandten Seite allmählich bis zur Grundseite 2 hin ab.

Weiter zeigt Figur 1 noch eine in die Grundseite 2 an der Innenseite eingeformte Nut 10, die mit geringerem Abstand vor der Kontaktfläche 15 des Vorsrunges 16 angeordnet ist. Wie man dazu Figur 2 weiter entnimmt, ist in diese Nut 10 eine Leiterplatte 12 einsteckbar, die mit einer Vielzahl von elektrischen oder elektronischen Bauteilen bestückt werden kann, die im Inneren des U-Profils 1 Platz finden, jedoch in der Zeichnung nicht wiedergegeben sind..Denn hier geht es vornehmlich um diejenigen elektronischen Bauteile 13, wie Leistungshalbleiter, die mit Wärmekontaktelementen 14 ausgestattet sind, bei denen es sich um eine Gehäuseseite oder -fläche des jeweiligen Bauteils 13 handeln kann. Diese Bauteile 13 sind bei der eingesteckten Leiterplatte 12 bezogen auf die Grundseite 2 des U-Profils 1 in Höhe des an der Flanschseite 4 sitzenden Druckteils 7 angeordnet, welches zunächst beim Einsetzen der Leiterplatte 12 aufgrund der geneigten Ausgangslage der Flanschseite 4 einen Abstand von der Leiterplatte 12 hält. Sitzt die Leiterplate 12 in der vorbestimmten Einbaulage, wird die zunächst geneigte Flanschseite 4 des U-Profils 1 gerichtet, also durch Schwenken um den verformbaren Wandabschnitt 5 im Übergangsbereich, der somit die Schwenkachse bildet, in die zur Grundseite 2 senkrechte bzw. zur gegenüberliegenden Flanschseite 3 parallele Lage gebracht. Hiernach beaufschlagt das Druckteil 7 an der Innenseite der Flanschseite 4 die Leiterplatte 12 in Höhe der Bauteile 13 bzw. ihrer Wärmekontaktelemente 14, jedoch auf der von diesen Bauteilen abgelegenen Seite. Hierdurch werden die Wärmekontaktelemente 14 der Bauteile 13 gegen die am Vorsprung 16 der Grundseite 2 befindliche Kontaktfläche 15 gepreßt, womit ein sehr guter Wärmekontakt zur Ableitung der Verlustwärme von den Bauteilen 13 in den Vorsprung 16 an der Grundseite 2 und damit in das gesamte U-Profil 1 besteht. Auf die gleiche Weise kann auch ein elektrischer Potentialausgleich zwischen der Leiterplatte 12 und dem U-Profil 1 hergestellt werden.

Die der Grundseite 2 des U-Profils 1 gegenüberliegende Gehäuseseite wird durch eine Abdeckhaube 8 gebildet, die an ihrer Innenseite zwischen zwei Stegen eine Nut 11 aufweist, die der Nut 10 in der Grundseite des U-Profils 1 derart gegenüberleigt, daß die Leiterplatte 12 in paralleler Ausrichtung mit der gerichteten Flanschseite 4 darin zur weiteren mechanischen Sicherung eingreifen kann. Die Abdeckhaube 8 übergreift beide Flanschseiten 3 und 4 an ihren Außenseiten, wobei die Abdeckhaube 8 und die Flanschseiten 3 und 4 im Überdeckungsbereich miteinander korrespondierende Rastelemente 9 haben, damit die Abdeckhaube 8 in einfacher Weise auf das offene Gehäuse aufgerastet werden kann.

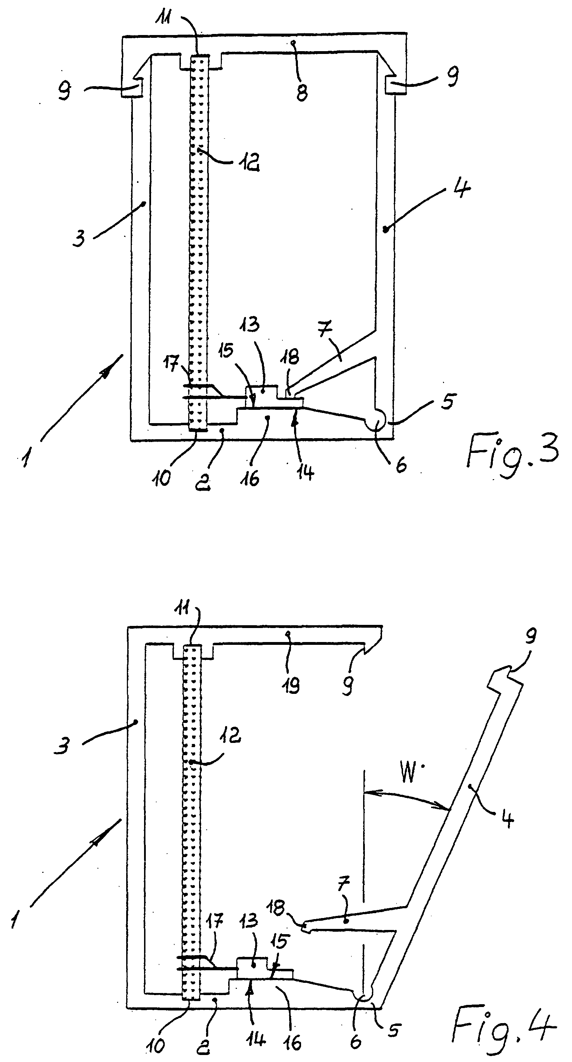

Fig. 3 zeigt ein bestücktes Gehäuses, welches hinsichtlich des äußeren Aufbaus auf der Basis des U-förmigen Kasten-Profils 1 der Ausführung nach Fig. 2 entspricht. Im Innern des Gehäuses ergeben sich Unterschiede insoweit, als hier die Leiterplatte 12 mit dem daran angeschlossenen Bauteil 13 so angeordnet ist, daß das Druckteil 7 an der richtbaren Flanschseite 4 das Bauteil 13 unmittelbar beaufschlagen und gegen den anders ausgebildeten Vorsprung 16 an der Grundseite 2 verspannen kann. Das Bauteil 13 ist über verlängerte Anschlußfahnen 17 an der Leiterplatte 12 angeschlossen, die nahe der nicht richtbaren Flanschseite 3 sowie parallel zu dieser angeordnet ist. Die Kontaktfläche 15 des Vorsprungs 16 an der Grundseite 2 erstreckt sich in einer Ebene, die senkrecht auf der Flanschseite 3 sowie auf der gerichteten Flanschseite 4 steht. Das Druckteil. 7 an der richtbaren Flanschseite 4 wirkt bei dieser Ausführung als Hebel und beaufschlagt das Bauteil 13 an der von der Grundseite 2 des Profils 1 abliegenden Oberseite. Beim Verschwenken der richtbaren Flanschseite 4 ergibt sich am Ende des Druckteils 7 ein Drehmoment, mit dem die Anpreßkraft erzeugt wird, durch die das Wärmekontaktelement 14 am Bauteil 13 gegen die Kontaktfläche 15 verspannt wird. Um die Biegespannungen im Druckteil 7 an der richtbaren Flanschseite 4 in Grenzen zu halten, ist das Druckteil 7 derart an der Innenseite der richtbaren Flanschseite 4 vorstehend angeordnet, daß es in der gerichteten Endlage der Flanschseite 4 zum Bauteil 13 hin geneigt angeordnet ist. An dem das Bauteil 13 beaufschlagenden Ende des Druckteils 7 kann zudem noch eine Abwinklung 18 vorgesehen sein, die senkrecht zum Wärmekontaktelement 14 des Bauteils 13 bzw. senkrecht zur Kontaktfläche 15 am Vorsprung 16 der Grundseite 2 gerichtet ist.

Fig. 4 zeigt eine Gehäuseausführung, deren innerer Aufbau dem Gehäuse von Fig. 3 entspricht. Hier wird also auch das zu kühlende Bauteil 13 unmittelbar beaufschlagt, um es gegen die gehäuseseitige Kontaktfläche 15 zu verspannen. Das das Kasten-Profil 1 bildende Strangpreßprofil ist hier jedoch im wesentlichen C-förmig ausgebildet, was bedeutet, daß die vierte Umfangsseite einstückig mit den übrigen Umfangsseiten ist. So gibt es auch hier eine Grundseite 2, eine erste rechtwinklig dazu stehende Seite 3, die an der Grundseite richtbar angeordnete Seite 4 und gegenüberliegend der Grundseite 2 eine Deckseite 19. Im Grunde genommen ersetzt die Deckseite 19 des C-förmigen Kasten-Profils 1 die Abdeckhaube des U-förmigen Kasten-Profils 1 nach den vorherigen Figuren. Die Zugänglichkeit zum Innern des C-förmigen Kastenprofils 1 muß durch einen entsprechend großen Öffnungswinkel W der richtbaren Seite 4 sichergestellt werden. Im übrigen erfolgt das Verschwenken der richtbaren Seite 4 unter gleichzeitiger Herstellung des Wärmeableitkontaktes für das Bauteil 13 in gleicher Weise wie bei den vorstehend beschriebenen Ausführungen. Hierbei kann die richtbare Seite 4 mit der Deckseite 19 verrastet werden, entsprechend sind an den freien Enden der richtbaren Seite 4 und der Deckseite 19 Rastmittel 9 vorhanden. Eine separat fügbare Abdeckhaube kann somit bei dieser Ausführung mit C-förmigem Kasten-Profil 1 entfallen.

## Patentansprüche

1. Wärmeableitendes Gehäuse zur Aufnahme zumindest einer Leiterplatte (12) mit wenigstens einem elektrischen oder elektronischen, mit einem Wärmekontaktelement (14) versehenen Bauteil (13), mit Umfangsseiten bestehend aus einem einstückigen Strangpreßprofil (1) aus Leichtmetall, wie einem U-Profil, welches die Basis des Gehäuses bildet und innenseitige Aufnahmekonturen (10, 11) für die Leiterplatte (12) sowie eine Kontaktfläche (15) zur Anlage des Wärmekontaktelementes (14) des betreffenden Bauteils (13) hat,
**dadurch gekennzeichnet,**
**daß** in einer Ausgangslage zumindest eine der Seiten (3, 4) relativ zu einer anderen Seite (2) des Profils (1) um einen Winkel (W) aufweitbar oder aufgeweitet und in der Einbaulage die Leiterplatte (12) mit dem Bauteil (13) in dem Profil (1) so angeordnet ist, daß mittels Richten der betreffenden Seite (3, 4) in ihre Endlage durch Verformung im Übergangsbereich zu der anderen Seite (2) hin bei Rückstellen dieses Winkels (W) unter dadurch bewirkter Druckbeaufschlagung des Bauteils (13) dessen Wärmekontaktelement (14) gegen die Kontaktfläche (15) gepreßt ist.

2. Gehäuse nach Anspruch 1,
**dadurch gekennzeichnet,**
**daß** zum Aufweiten oder Richten die betreffende Seite (4) mit der Seite (2), der Grundseite des Profils (1) über einen nach Art eines Filmscharniers verformbaren Wandabschnitt (5) verbunden ist.

3. Gehäuse nach Anspruch 1 oder 2,
**dadurch gekennzeichnet,**
**daß** die richtbare Seite (4) des Profils (1) ein vorstehendes Druckteil (7) hat, welches in der gerichteten Endlage der Seite (4) das Bauteil (13) unmittelbar beaufschlagt.

4. Gehäuse nach Anspruch 1 oder 2,
**dadurch gekennzeichnet,**
**daß** das vorstehende Druckteil (7) der richtbaren Seite (4) des Profils (1) in der gerichteten Endlage der Seite (4) das Bauteil (13) mittelbar über die zwischen dem Druckteil (7) und dem Bauteil (13) angeordnete Leiterplatte (12) beaufschlagt.

5. Gehäuse nach Anspruch 3 oder 4,
**dadurch gekennzeichnet,**
**daß** das Wärmekontaktelement (14) des Bauteils (13) an der der richtbaren Seite (4) des Profils (1) abgewandten Seite der Leiterplatte (12) angeordnet ist und sich die Kontaktfläche (15) an der Grundseite (2) und/oder an der gegenüberliegenden Seite (3) des Profils (1) befindet.

6. Gehäuse nach Anspruch 3 oder 4,
**dadurch gekennzeichnet,**
**daß** zumindest das Wärmekontaktelement (14) des Bauteils (13) oder das gesamte Bauteil 13 an der der richtbaren Seite (4) des Profils (1) zugewandten Seite der Leiterplatte (12) angeordnet ist und in der Endlage das Druckteil (7) der richtbaren Flanschseite (4) das Bauteil (13) oder wenigstens dessen Wärmekontaktelement (14) gegen die an der Grundseite (2) des Profils (1) befindliche Kontaktfläche (15) verspannt.

7. Gehäuse nach Anspruch 5 oder 6,
**dadurch gekennzeichnet,**
**daß** die Kontaktfläche (15) an einem massiven, mit der Grundseite (2) einstückigen Vorsprung (16) im Inneren des Profils (1) angeordnet ist.

8. Gehäuse nach einem der Ansprüche 5 bis 7,
**dadurch gekennzeichnet,**
**daß** die Leiterplatte (12) im Profil (1) parallel zu der in der Endlage befindlichen, richtbaren Seite (4) angeordnet ist.

9. Gehäuse nach Anspruch 8,
**dadurch gekennzeichnet,**
**daß** das zumindest eine Wärmekontaktelement (14) des wenigstens einen Bauteils (13) an oder nahe dem zur Grundseite (2) des Profils (1) hin liegenden Ende.der Leiterplatte (12) angeordnet ist.

10. Gehäuse nach einem der Ansprüche 7 bis 9,
**dadurch gekennzeichnet,**
**daß** die Kontaktfläche (15) am Vorsprung (16) an der Grundseite (2) des Profils (1) parallel zur Leiterplatte (12) sowie zum Kontaktelement (14) an dem jeweiligen Bauteil (13) ist und der Vorsprung (16) einen sich zur Kontaktfläche (15) hin vergrößernden Querschnitt hat.

11. Gehäuse nach einem der Ansprüche 7 bis 9
**dadurch gekennzeichnet,**
**daß** die Kontaktfläche (15) am Vorsprung (16) an der Grundseite (2) des Profils (1) senkrecht zu den Seiten (3, 4) liegt und das Druckteil (7) an der richtbaren Seite (4) geneigt zu der Kontaktfläche (4) in der Spannlage angeordnet ist.

12. Gehäuse nach einem der Ansprüche 1 bis 11,
**dadurch gekennzeichnet,**
**daß** das Profil (1) U-förmig ist und darauf eine dessen als Flanschseiten ausgebildeten Seiten (4, 3) außenseitig übergreifende Abdeckhaube (8) aufsetzbar ist.

13. Gehäuse nach Anspruch 12,
**dadurch gekennzeichnet,**
**daß** die Abdeckhaube (8) im Übergriffsbereich und außenseitig die Seiten (3, 4) des U-förmigen Profils (1) miteinander korrespondierende Rastmittel (9) aufweisen.

14. Gehäuse nach einem der Ansprüche 1 bis 13,
**dadurch gekennzeichnet,**
**daß** das Profil (1) etwa C-förmig ist und der Grundseite (2) eine an der einen Seite (3) abgewinkelte Deckseite (19) gegenüberliegt, welche die mit der richtbaren Seite (4) zusammenwirkenden Rastmittel (9) aufweist.

15. Gehäuse nach einem der Ansprüche 12 bis 14,
**dadurch gekennzeichnet,**
**daß** die Abdeckhaube (8) oder die Deckseite (19) und die Grundseite (2) des Profils (1) einander gegenüberliegende Nuten (11, 10) zur Aufnahme der Leiterplatte (12) haben.

## Claims

1. Heat-conducting housing to accommodate at least one conductor plate (12) having at least one electrical or electronic component part (13) provided with a heat contact element (14), with peripheral sides, the housing comprising a one-piece pressed extruded profiled section (1) of light metal, such as a U-shaped profiled section which forms the basis of the housing and has internal contours (10, 11) for accommodating the conductor plate (12) as well as a contact surface (15) for bearing against the heat contact element (14) of the relevant component part (13),
**characterised in that**
in a starting position at least one of the sides (3, 4) is opened out or can be opened out about by an angle (W) relative to another side (2) of the profiled section (1), and in the installation position the conductor plate (12) is arranged with the component part (13) in the profiled section (1) so that by lining up the relevant side (3, 4) vertically into its end position through deformation in the area where it joins the other side (2), as this angle (W) is reset the ensuing pressure on the component part (13) ensures that its heat contact element (14) is pressed against the contact surface (15).

2. Housing according to claim 1 **characterised in that** in order to open out or vertically line up the relevant side (4) said side is connected to the side (2), the base side of the profiled section (1), through a wall section (5) which can be deformed in the manner of a film hinge.

3. Housing according to claim 1 or 2 **characterised in that** the side (4) of the profiled section (1) which is to be lined up has a protruding pressure part (7) which in the aligned end position of this side (4) directly impinges on the component part (13).

4. Housing according to claim 1 or 2 **characterised in that** the protruding pressure part (7) of the movable side (4) of the profiled section, when this side (4) is in the aligned end position, impinges on the component part (13) indirectly through the conductor plate (12) which is mounted between the pressure part (7) and the component part (13).

5. Housing according to claim 3 or 4 **characterised in that** the heat contact element (14) of the component part (13) is mounted on the side of the conductor plate (12) remote from the movable side (4) of the profiled section (1), and the contact face (15) is located on the base side (2) and/or on the opposite side (3) of the profiled section (1).

6. Housing according to claim 3 or 4 **characterised in that** at least the heat contact element (14) of the component part (13) or the complete component part (13) is mounted on the side of the conductor plate (12) facing the movable side (4) of the profiled section (1), and in the end position the pressure part (7) of the movable flange side (4) clamps the component part (13) or at least the heat contact element (14) thereof against the contact surface (15) which is located on the base side (2) of the profiled section (1).

7. Housing according to claim 5 or 6 **characterised in that** the contact surface (15) is mounted on a solid projection (16) set inside the profiled section (1) and integral with the base side (2) thereof.

8. Housing according to one of claims 5 to 7 **characterised in that** the conductor plate (12) is mounted in the profiled section (1) parallel to the movable side (4) when the latter is located in the end position.

9. Housing according to claim 8 **characterised in that** the at least one heat contact element (14) of the at least one component part (13) is mounted on or close to the end of the conductor plate (12) which lies towards the base side (2) of the profiled section (1).

10. Housing according to one of claims 7 to 9 **characterised in that** the contact surface (15) on the projection (16) on the base side (2) of the profiled section (1) is parallel to the conductor plate (12) and to the contact element (14) on the relevant component part (13), and the projection (16) has a cross-sectional shape which increases towards the contact surface (15).

11. Housing according to one of claims 7 to 9 **characterised in that** the contact surface (15) on the projection (16) on the base side (2) of the profiled section (1) lies perpendicular to the sides (3, 4), and the pressure part (7) is mounted on the movable side (4) inclined to the contact surface (4) in the tensioned positioned.

12. Housing according to one of claims 1 to 11 **characterised in that** the profiled section (1) is U-shaped and a cover hood (8) can be fitted thereon which engages on the outside over the sides (4, 3) which are formed as the flange sides of the profiled section.

13. Housing according to claim 12 **characterised in that** the engagement area of the cover hood (8) and the outsides of the sides (3, 4) of the U-shaped profiled section (1) have detent means (9) which correspond with each other.

14. Housing according to one of claims 1 to 13 **characterised in that** the profiled section (1) is roughly C-shaped and opposite the base side (2) is a top side (19) which is angled on one side (3) and has the detent means (9) which interact with the movable side (4).

15. Housing according to one of claims 12 to 14 **characterised in that** the cover hood (8) or the top side (19) and the base side (2) of the profiled section (1) have opposing grooves (11, 10) to accommodate the conductor plate (12).

## Revendications

1. Boitier dissipateur de chaleur destiné à recevoir au moins une plaquette (12) comprenant au moins un composant électrique ou électronique (13), pourvu d'un élément de contact thermique (14), les côtés et la base dudit boitier étant formés d'une seule pièce par un profilé extrudé (1) en métal léger, tel qu'un profilé en U, des contours intérieurs de réception (10, 11) étant formés pour accueillir la plaquette (12) et une surface de contact (15), contre laquelle l'élément de contact thermique (14) dudit composant (13) vient porter, étant prévue,
**caractérisé en ce que**,
dans une position initiale, l'un des côtés (3, 4), au moins, est disposé par rapport à un autre côté (2) du profilé (1) en formant un angle (W) extensible ou élargi et que, lors de l'incorporation de la plaquette (12) avec composant électrique ou électronique (13), ladite plaquette (12)se trouve disposée dans le profilé (1) de sorte que, dans la position finale, l'élément de contact thermique (14) soit pressé contre la surface de contact (15) par redressage dudit côté (3, 4) et déformation de la zone intermédiaire en direction de l'autre côté (2), lors du rétablissement de cet angle (W), par pression ainsi exercée sur le composant (13).

2. Boitier selon la revendication 1,
**caractérisé en ce que**,
pour permettre l'élargissement ou le redressage, ledit côté (4) est relié au côté qui forme la surface de base (2) du profilé (1), par un secteur de paroi (5) déformable à la manière d'une charnière pelliculaire.

3. Boitier selon la revendication 1 ou 2,
**caractérisé en ce que**
le côté redressable (4) du profilé (1) présente un élément de pression en saillie à l'action duquel le composant 13 est soumis directement.

4. Boitier selon la revendication 1 ou 2,
**caractérisé en ce que**
l'élément de pression en saillie (7), formé à partir du côté redressable (4) du profilé (1), agit indirectement sur le composant (13) par l'intermédiaire de la plaquette (12) qui est disposée entre cet élément de pression (7) et le composant (13).

5. Boitier selon la revendication 3 ou 4,
**caractérisé en ce que**
l'élément de contact thermique (14) du composant (13) est disposé sur le côté de la plaquette (12) opposé au côté redressable (4) du profilé (1) et que la surface de contact (15) est ordonnée sur le côté formant la surface de base (2) et / ou sur le côté (3) du profilé (1) situé vis-à-vis.

6. Boitier selon la revendication 3 ou 4,
**caractérisé en ce que**
l'élément de contact thermique (14) du composant (13), au moins, ou la totalité de ce composant (13) est disposé sur le côté de la plaquette (12) dirigé vers le côté redressable (4) du profilé (1) et que, dans la position finale, l'élément de pression (7), formé à partir du côté redressable (4), serre le composant (13) ou, tout au moins, son élément de contact thermique (14) contre la surface de contact (15) prévue sur la surface de base (2) du profilé (1).

7. Boitier selon la revendication 5 ou 6,
**caractérisé en ce que**
la surface de contact (15) est disposée, à l'intérieur du profilé (1), contre une saillie (16) qui est formée d'une pièce avec la surface de base (2).

8. Boitier selon l'une des revendications 5 à 7,
**caractérisé en ce que**
la plaquette (12) est disposée, dans le profilé (1), parallèlement au côté redressable (4) quand celui-ci se trouve en position finale.

9. Boitier selon la revendication 8,
**caractérisé en ce que**,
au moins, un élément de contact thermique (14), d'au moins un constituant électrique ou électronique (13), est disposé contre ou à proximité de l'extrémité de la plaquette (12) orientée vers la surface de base (2) du profilé (1).

10. Boitier selon l'une des revendications 7 à 9,
**caractérisé en ce que**
la surface de contact (15) adjacente à la saillie (16) de la surface de base (2) du profilé (1) s'étend parallèlement à la plaquette (12) ainsi qu'à l'élément de contact (14) du composant respectif (13) et que la saillie (16) présente une section transversale qui augmente en direction de la surface de contact (15).

11. Boitier selon l'une des revendications 7 à 9,
**caractérisé en ce que**
la surface de contact (15) portant contre la saillie (16), formée à partir de la surface de base (2) du profilé (1), s'étend perpendiculairement par rapport au côté (3, 4) et que l'élément de pression (7), équipant le côté redressable (4), oblique en direction de la surface de contact (15), en position de serrage.

12. Boitier selon l'une des revendications 1 à 11,
**caractérisé en ce que**
le profilé (1) est coudé en U et peut être fermé par un couvercle (8) qui, posé sur lui, embrasse, extérieurement, ses côtés (4, 3) en forme de flasques.

13. Boitier selon la revendication 12,
**caractérisé en ce que**,
le couvercle (8), dans la zone de recouvrement, et les surfaces extérieures des côtés (3, 4) du profilé en U (1) présentent des moyens d'arrêt (9) concordant entre eux.

14. Boitier selon l'une des revendications 1 à 13,
**caractérisé en ce que**
le profilé (1) présente approximativement la forme d'un C et qu'une surface de recouvrement (19), coudée à partir de l'un des côtés (3) du profilé (1), est située à l'opposé de la surface de base (2), cette surface de recouvrement (19) présentant des moyens d'arrêt (9) qui concourent avec le côté redressable (4).

15. Boitier selon l'une des revendications 12 à 14,
**caractérisé en ce que**
le couvercle (8) ou la surface de recouvrement (19) et la surface de base (2) du profilé (1) sont pourvus d'encoches (11, 10), disposées vis-à-vis l'une de l'autre et destinées à recevoir la plaquette (12).
